# EUROPÄISCHE PATENTSCHRIFT

(11) **EP 1 374 392 B1**
(45) Veröffentlichungstag und Bekanntmachung des Hinweises auf die Patenterteilung: **25.01.2006**
(21) Anmeldenummer: 01929456.0
(22) Anmeldetag: 26.03.2001
(51) Int. Cl.: H03F 1/56

(54) **VERSTÄRKERSCHALTUNG**
AMPLIFYING CIRCUIT
MONTAGE AMPLIFICATEUR

(43) Veröffentlichungstag der Anmeldung: 02.01.2004
(73) Patentinhaber: Georg Neumann GmbH, 13403 Berlin (DE)
(72) Erfinder: KERN, Otmar, 14167 Berlin (DE)
(74) Vertreter: Konle, Tilmar
(86) Internationale Anmeldenummer: PCT/EP2001/003410
(87) Internationale Veröffentlichungsnummer: WO 2002/078177

(56) Entgegenhaltungen:
- EP-A- 0 880 225
- US-A- 3 595 998
- US-A- 5 589 799

## Beschreibung

Die Erfindung bezieht sich auf eine Verstärkerschaltung gemäß dem Oberbegriff des Patentanspruchs 1. Eine derartige Verstärkerschaltung ist aus der US 3 595 998 A bekannt.

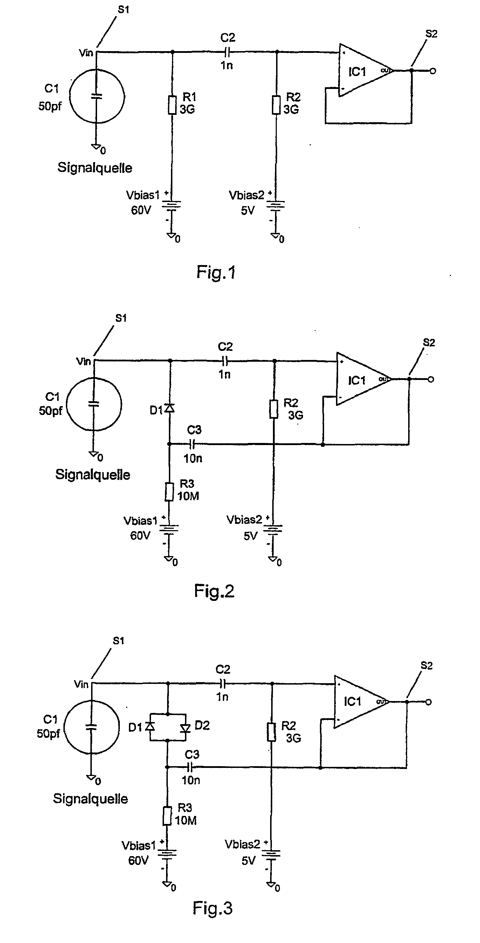

Zur Arbeitspunkteinstellung an hochohmigen Verstärkereingängen und zur Vorspannungsankogplung an kapazitive Signalquellen werden üblicherweise hochohmige Widerstände benutzt. Eine entsprechende Schaltungsanordnung gemäß dem Stand der Technik ist in Fig. 1 dargestellt. Dort ist mit C1 eine kapazitive Signalquelle von 50pF in Form einer Kondensatormikrofonkapsel dargestellt welche über einen hochohmigen Widerstand R1 von 3GOhm an eine Versorgungsgleichspannung Vbias1 von +60V angekoppelt ist. Das Nutzsignal S1 der kapazitiven Signalquelle C1, beispielsweise ein Audiosignal, wird über einen Längskondensator C2 von 1nF (der zur Trennung der Arbeitspunktspannungen in den Signalweg eingefügt ist) dem hochohmigen, nicht-invertierenden Eingang (+) eines Verstärkers IC1 zugeführt Das Ausgangssignal S2 des Verstärkers IC1 ist auf den invertierenden Eingang (-) des Verstärkers IC1 im Sinne einer. Gegenkopplung zurückgeführt. Hierdurch ergibt sich hinsichtlich der Signalspannung eine Verstärkung von V=1, wobei das Ausgangssignal S2 mit einer niedrigen Quellimpedanz zur Verfügung steht und die nach Betrag und Phase gleiche Nutzsignalinformation wie das Signal S1 trägt. Zur Einstellung des Arbeitspunktes des Verstärkers IC1 ist eine Vorspannungsquelle Vbias2 von +5V vorgesehen, welche über einen hochohmigen Widerstand R2 von 3 GOhm auf den nicht-invertierenden Eingang (+) des Verstärkers IC1 gekoppelt ist.

Eine ähnliche Schalnmgsanordnung wie in Figur 1 ist aus der US 3 595 998 A bekannt. Diese bekannte Verstärkerschaltung weist ebenfalls eine Kondensatormikrofonkapsel M als kapazitive Spannungsquelle auf, deren Arbeitspunkt durch einen ohmschen Widerstand Rᵥ bestimmt wird, welcher an eine erste Vorspannungsquelle Uₚ angeschlossen ist. Zur Entkopplung zwischen der ersten Vorspannungsquelle Uₚ und einer zweiten Vorspannungsquelle U_{B} zur Arbeitspunkteinstellung des nachgeschalteten Verstärkers ist in den Signalweg zwischen der Kondensatormikrofonkapsel M und der Gate-Elektrode 3 des Verstärker-FET-Transistors eine Kopplungskapazität Cₖ angeordnet. Der Arbeitspunkt des Verstärker-Transistors wird durch ein Widerstands-Teilernetzwerk bestimmt, welches die ohmschen Widerstände R₁, R₂, R₃, Rᵥ sowie eine Diode D umfaßt. Für die Vorspannungsquelle U_{B} können Stromversorgungsspannungen beliebiger Polarität verwendet werden, da Feldeffekttransistoren im allgemeinen symmetrisch ausgebaut sind, so daß die Source- und Drain-Elektroden abhängig von der angelegten Spannung die Funktion tauschen, d.h. die Elektrode mit der jeweils negativeren Spannung (beim N-Kanal-Typ) übernimmt die Rolle der Source. Die Gewinnung des Ausgangssignals geschieht symmetrisch in gleicher Weise an der Source- und Drain-Elektrode durch die Bauelemente R₄, R₅, C und Tr. Lediglich die Arbeitsspannung an der Crate-Elektrode muß abhängig von der Polarität der Stromversorgungsspannung angepasst werden, da sie im allgemeinen nicht der halben Stromversorgungsspannung entspricht. Dies geschieht durch die erwähnte Diode D in Reihe mit dem Widerstand R₂. Für den Fall einer negativen Versorgungsspannung wird der Arbeitspunkt für den Verstärker-FET-Transistors durch den Spannungsteiler R1/R3 hergestellt. Die Diode D ist in diesem Fall gesperrt und ist wirkungslos. Im Falle einer positiven Stromversorgungsspannung wird ein umgekehrtes Spannungsteilerverhältnis erforderlich. Dies wird dadurch erreicht, daß die Diode D nunmehr leitend ist und der Widerstand R2 dem Widerstand R3 parallel geschaltet wird.

Der theoretisch erforderliche Minimalwert der Kopplungswiderstände R1, R2 bzw. Rᵥ ergibt sich zunächst aus der gewünschten unteren Grenzfrequenz des zu übertragenden Nutzsignals S1. Beispielsweise wäre der resultierende Wert der hinsichtlich der Belastung der Signalquelle C1 parallel wirkenden Kopplungswiderstände R1, R2 bzw. Rᵥ (deren Parallelschaltung als Belastung der Signalquelle wirksam ist) bei einer unteren Grenzfrequenz von 20Hz und einer Signalquellenkapazität von 50pF auf 160Mohm festzulegen. Ein solcher Widerstandswert erzeugt indessen eine sehr hohe Rauschspannung, die allerdings entsprechend der Spannungsteilung im Verhältnis des Widerstandswertes der Parallelschaltung aus den beiden Kopplungswiderständen R1, R2 bzw. Rᵥ zum Wert der Impedanz der kapazitiven Signalquelle vermindert wird.

Dabei gilt ebenfalls, daß bei Erhöhung des Widerstandswertes der Parallelschaltung aus den Widerständen R1, R2 bzw. Rᵥ um einen bestimmten Faktor die Rauschspannung um diesen Faktor weiter vermindert wird; dagegen steigt die in den parallelen Widerständen R1, R2 bzw. Rᵥ generierte Rauschspannung gemäß bekannten physikalischen Gesetzmäßigkeiten nur um die Wurzel aus dem genannten Faktor an. Rechnerisch bedeutet dies, daß mit jeder Verdoppehmg des Widerstandswertes ein Rauschgewinn von 3dB erzielt wird.

Allerdings ist mit dieser Widerstandserhöhung auch ein erheblicher Nachteil verbunden: Die Zeit, die nach Aufschalten der Arbeitsspannungen Vbias 1 und Vbias 2 (Einschalten des Geräts) oder Umschalten der Vorspannung Vbias1 an der kapazitiven Signalquelle zum Laden der Quellkapazität und des erforderlichen Kopplungskondensators vergeht, steigt ebenfalls linear an. In der Praxis werden üblicherweise Widerstandswerte von 1 bis 3GOhm verwendet. Die hierbei entstehenden Lade- bzw. Totzeiten stellen sich bei herkömmlichen analogen Mikrofonen im Bereich von 10 bis 15 Sekunden, bei Mikrofonen mit Analog-Digital-Wandlung wegen erhöhter Arbeitspunkt-Anforderungen mit mehr als 30 Sekunden ein. Dennoch wäre eine weitere Erhöhung des Widerstandswertes mit dem Ziel eines Rauschgewinns wünschenswert, da erst bei etwa 10 bis 20GOhm eine weitgehende Überdeckung durch andere Rauschquellen stattfindet. Auch ist zu erwarten, daß für den Fall einer weiteren Erhöhung des Widerstandswerts für R1, R2 bzw. Rᵥ die angekoppelten Arbeitspunktspannungen an der Signalquelle bzw. am nicht-invertierenden Eingang (+) des Verstärkers in der Praxis wegen immer vorhandener, unvermeidlicher Leckströme sehr ungenau werden.

Es ist ferner aus der EP 0 880 225 A2 bekannt, das Ausgangssignal des Verstärkers auf den Verbindungspunkt einer Serienschaltung aus einem hochohmigen Vorwiderstand zwei antiparallel angeordneten Dioden rückzukoppeln, welche zur Arbeitspunkteinstellung des Verstärkers vorgesehen ist. Und zwar wird durch diese Rückkopplung bei der Entgegenhaltung erreicht, daß an beiden Enden der antiparallel angeordneten Dioden (Fig. 2 bis 5) annähernd keine Differenzspannung entsteht, so daß die schädliche Kapazität parallel zu den Dioden ohne Wirkung bleibt. Bei der Schaltung nach der EP 0 880 225 A2 wird indessen der Arbeitspunkt der Signalquelle nicht über eine gesonderte Vorspannungsquelle eingestellt, so daß auch keine Kopplungskapazität im Signalweg zwischen Signalquelle und Verstärker vorhanden ist. Die Frage nach einer möglichst geringen Ladezeit einer solchen fehlenden Kopplungskapazität stellt sich daher bei dieser bekannten Schaltung nicht. Die gleiche Feststellung gilt für die Verstärkerschaltung nach der US 5 589 799 A, bei welcher ebenfalls keine vorgespannte Mikrofonkapsel als Signalquelle und damit auch keine Kopplungskapazität im Signalweg zwischen Signalquelle und Verstärker vorgesehen sind.

Die Aufgabe der Erfindung besteht darin, bei einer Verstärkerschaltung der eingangs erwähnten Art einen erheblichen Rauschgewinn zu erzielen, ohne den Nachteil sehr hoher Totzeiten und eines zu großen Einflusses von Leckströmen in Kauf nehmen zu müssen.

Diese Aufgabe wird erfindungsgemäß durch die kennzeichnenden Merkmale des Patentanspruchs 1 gelöst.

Vorteilhafte Ausgestaltungen und Weiterbildungen der Verstärkerschaltung nach Anspruch 1 ergeben sich aus den Unteransprüchen.

Der Erfindung liegt die Überlegung zugrunde, die Kopplungswiderstände R1, R2 durch je ein Netzwerk zu ersetzen, welches aus der Reihenschaltung eines nichtlinearen Widerstands und eines ohmschen Kopplungswiderstands besteht. Der Kopplungswiderstand, welcher die Ladezeiten der Quellkapazität und der Kopplungskapazität C2 bestimmt, kann verhältnismäßig klein bemessen werden, da der nichtlineare Widerstand während der Ladezeiten mit niedriger Impedanz leitend ist und nach erfolgter Aufladung der Quellkapazität und der Kopplungskapazität automatisch einen solchen hohen Widerstandswert annimmt, der zur Verbesserung des Rauschverhaltens erforderlich ist.

Die Erfindung wird an Hand der Figuren 2 bis 5 näher erläutert. Es zeigt:
- Fig.2: ein elektrisches Prinzipschaltbild einer erfindungsgemäßen Verstärkerschaltung;
- Fig. 3: ein weiteres elektrisches Prinzipschaltbild einer erfindungsgemäßen Verstärkerschaltung;
- Fig. 4: ein Schaltbild einer bevorzugten Ausführungsform einer erfindungsgemäßen Verstärkerschaltung, und
- Fig. 5: ein elektrisches Schaltbild einer weiteren bevorzugten Ausführungsform einer erfindungsgemäßen Verstärkerschaltung.

Bei dem in Figur 2 dargestellten Prinzschaltbild ist im Vergleich zum Stand der Technik nach Fig. 1 der Kopplungswiderstand R1 durch die Serienschaltung eines nichtlinearen Widerstandes in Form einer Diode D1 und eines ohmschen Widerstandes R3 ersetzt. Durch diese Maßnahme wird die Vorspannung Vbias1 über das Bauelement D1 mit nichtlinearer Strom-Spannungskennlinie geführt, das in Reihe mit dem Widerstand R3 geschaltet ist. Nach dem Auf- bzw. Umladen der Kapazitäten C1 und C2 fließt praktisch kein Strom mehr, so daß sich dann die Diode D1 im gesperrten Zustand befindet, da zwischen den beiden Anschlußenden der Diode D1 keine Spannung anliegt. Die in der Diode D1 generierte Rauschspannung ist deshalb sehr klein und basiert auf kleinen unvermeidlichen Leckströmen in der Gesamtschaltung. Hingegen wird während des Aufladens der Kapazitäten C1, C2 die Diode D1 leitend, wobei die Ladeströme und -zeiten durch den in Reihe geschalteten ohmschen Widerstand R3 bestimmt werden, welcher gegenüber dem Kopplungswiderstand R1 gemäß Fig. 1 einen um den Faktor 300 kleineren Widerstandswert von lediglich 10Mohm besitzt.

Allerdings würde ohne weitere Maßnahme der leitende Zustand der Diode D1 wegen deren Strom-Spannungskennlinie im Durchlaßbereich auch durch das anliegende Wechselspannungs-Nutzsignal S1 hervorgerufen werden. Hierdurch würde eine schädliche und zudem nichtlineare Belastung der kapazitiven Signalquelle C1 auftreten, da diese eine sehr hohe Impedanz aufweist. Auch würde die im Kopplungswiderstand generierte Rauschspannung zumindest noch teilweise über die Diode D1 übertragen werden.

Zur völligen Unterbindung dieser unerwünschten Effekte ist ein Kondensator C3 vorgesehen, welcher das impedanzgewandelte Nutzsignal S2 vom Ausgang des Verstärkers IC1 (dessen Signalverstärkung auf V = 1 gesetzt ist) auf den Verbindungspunkt zwischen der Diode D1 und dem Widerstand R3 zurückführt. Diese Rückführung hat zur Folge, daß das Nutzsignal S2 an den beiden Enden der Diode D1 phasen- und betragsgleich anliegt, wodurch die Diode D1 völlig unabhängig von der Amplitude des Nutzsignals S2 stets im spannungslosen, d.h., gesperrten Zustand gehalten wird. Hieraus resultiert eine extrem hochohmige und rauscharme Zuführung der Betriebsspannung Vbias1 zur Signalquelle C1. Hingegen ist die Diode D1 bei der Umladung der Kapazitäten C1, C2 leitend, wobei die Umladezeit nur durch die Zeitkonstante R3/C2 bestimmt wird, die im Vergleich zum Stand der Technik gemäß Fig. 1 sehr klein ist. Die Dimensionierung der Zeitkonstante R3/C2 richtet sich nur nach der gewünschten unteren Grenzfrequenz, bei der die beschriebene Rückführung des Nutzsignals S2 noch ausreichend genau wirksam ist. Eine gewählte Grenzfrequenz von etwa einem Zehntel der tiefsten zu übertragenden Nutzfrequenz (bei Audiosignalen im allgemeinen 20Hz) erfüllt diese Bedingung ohne Einschränkung. Weiterhin wirkt der Kondensator C3 in der Weise, daß die durch den Kopplungswiderstand generierte Rauschspannung auf den Ausgang des Verstärkers IC1 kurzgeschlossen ist und somit nicht mehr schädlich in Erscheinung tritt.

In der Praxis kann es vorkommen, daß die Vorspannung Vbias1 der Signalquelle C1 während des Betriebs variiert wird, um beispielsweise die Empfindlichkeit oder die Richtcharakteristik bei einer Mikrofonkapsel verändern zu können. Insofern ist der beschriebene Wirkungsmechanismus nicht nur für das Aufladen der Kapazitäten C1, C2 nach Einschalten der Vorspannung Vbias1 von Bedeutung, sondern auch für das beschleunigte Entladen, wenn eine kleinere oder gar negative Vorspannung Vbias1 einstellbar sein soll. Für diesen Fall wird, wie Fig. 3 zeigt, der Diode D1 eine weitere Diode D2 antiparallel geschaltet, so daß die beschriebenen Ladevorgänge bipolar ablaufen können.

Die in Figuren 2 und 3 erläuterten Maßnahmen nach der Erfindung können auch zur Arbeitspunkteinstellung des Verstärkers bzw.

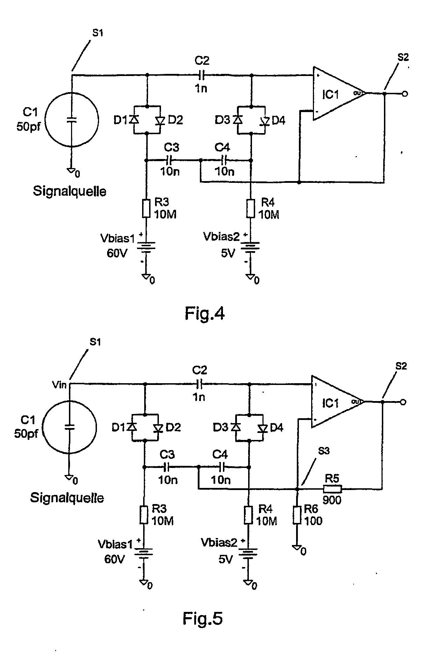

Impedanzwandlers IC1 verwendet werden. Hierzu wird, wie Fig. 4 zeigt, auch der Kopplungswiderstand R2 gemäß Fig. 1 durch ein Netzwerk, bestehend aus den Bauelementen R4, C4, D3 und D4, ersetzt. Dieses Netzwerk umfaßt wiederum eine Serienschaltung, bestehend aus zwei antiparallelen Dioden D3, D4, und einem in Serie dazu angeordneten ohmschen Kopplungswiderstand R4, ferner aus einer Kopplungskapazität C4 zum Rückführen des Nutzsignals S2 an den Verbindungspunkt zwischen dem Widerstand R4 und den Dioden D3, D4. Der zuvor an Hand von Fig. 3 beschriebene Wirkungsmechanismus ergibt sich damit in gleicher Weise auch für den Verstärker IC1.

Für den Fall, daß die Nutzsignalverstärkung des Verstärkers IC1 größer als 1 sein soll, wird die Ausführungsform gemäß Fig. 5 verwendet, bei welcher das auf den invertierenden Eingang (-) des Verstärkers IC1 im Sinne einer Gegenkopplung zurückgeführte Ausgangssignal S2 durch einen Widerstandsteiler, bestehend aus den ohm'schen Widerständen R5, R6, geteilt wird. Beispielsweise ergibt sich bei einem Teilerverhältnis von 10:1 eine Signalverstärkung von V=10, da sich am invertierenden Eingang (-) des Verstärkers IC1 immer ein betrags- und phasengleiches Signal S3 (verglichen mit dem Nutzsignal S1 am nicht-invertierenden Eingang (+) des Verstärkers IC1) einstellt. Für die Signalrückführung auf den Fußpunkt der Kapazitäten C3 und C4 wird im Falle des Ausführungsbeispiels nach Fig. 5 nicht das Ausgangssignal S2, sondern das davon abgeleitete, nämlich um das Teilerverhältnis R5/R6 geteilte Signal S3 benutzt.

Es versteht sich, daß anstelle der Dioden D1 bis D4 auch andere Bauelemente mit nichtlinearer Strom-Spannungskennlinie eingesetzt werden können, beispielsweise LEDs, Zenerdioden usw..

In der Praxis wird mit der erfindungsgemäß ausgebildeten Verstärkerschaltung abhängig von der gewählten Bewertungskurve für die Rauschsignalmessung ein um 2 bis 10dB verbesserter Signal-Rauschabstand erzielt, während gleichzeitig die unerwünschten Auf- und Umladezeiten auf kleiner als eine Sekunde vermindert werden.

## Patentansprüche

1. Verstärkerschaltung für tonfrequente Signale, mit einer Kondensatonnikrofonkapsel als kapazitiver Spannungsquelle, welche zur Bestimmung ihres Arbeitspunktes über eine erste Kopplungsimpedanz (R3, D1; R3, D1, D2) an eine erste Vorspannungsquelle (Vbias1) angekoppelt ist, mit einem Verstärker (IC1), welcher zur Bestimmung seines Arbeitspunktes mit seinem nicht-invertierenden Eingang über eine zweite Kopplungsimpedanz (R4, D3; R4, D3, D4) an eine zweite Vorspannungsquelle (Vbias2) angekoppelt ist, und mit einer Kopplungskapazität (C2), die im Signalweg zwischen der Kapsel und dem Verstärker (IC1) angeordnet ist, **dadurch gekennzeichnet, daß** die erste und zweite Kopplungsimpedanz (R3, D1; R3, D1, D2; R4, D3; R4, D3, D4) jeweils aus einer Reihenschaltung eines nicht-linearen Widerstandes (D1; D1, D2; D3; D3, D4) und eines ersten bzw. zweiten ohmschen Widerstandes . (R3; R4) mit verhältnismäßig kleinem Widerstandswert besteht, wobei der nicht-lineare Widerstand während der Lädezeiten der Kapazität (C1) der Kondensatormikrofonkapsel und der Kopplungskapazität (C2) im Signalweg zwischen Kapsel und Verstärker (IC1) leitend ist, so daß diese Ladezeiten von dem niederohmigen ersten bzw. zweiten ohmschen Widerstand (R3, R4) bestimmt werden, und wobei der nicht-lineare Widerstand (D1; D1, D2; D3; D3, D4) in jeder Kopplungsimpedanz nach erfolgter Aufladung der Kapazität (C1), der Kondensatormikrofonkapsel und der Kopplungskapazität (C2) im Signalweg zwischen Kapsel und Verstärker (IC1) einen hohen Widerstandswert annimmt, so daß von dem nicht-linearen Widerstand in jeder Kopplungsimpedanz nur eine sehr kleine Rauschspannung erzeugt wird, und daß das Ausgangssignal (S2) des Verstärkers (IC1) oder ein davon abgeleitetes Signal auf die erste und zweite Kopplungsimpedanz rückgekoppelt wird.

2. Verstärkerschaltung nach Anspruch 1, **dadurch gekennzeichnet, daß** als erster und zweiter nichtlinearer Widerstand jeweils eine Diode (D1 bzw. D3) vorgesehen ist.

3. Verstärkerschaltung nach Anspruch 1 oder 2, **dadurch gekennzeichnet, daß** als erster und zweiter nichtlinearer Widerstand jeweils eine Antiparallelschaltung zweier Dioden (D1, D2 bzw. D3, D4) vorgesehen ist.

4. Verstärkerschaltung nach einem der Ansprüche 1 bis 3, **dadurch gekennzeichnet, daß** das Ausgangssignal (S2) des Verstärkers (IC1) mit dem vollen Betrag seiner Amplitude sowohl auf den invertierenden Eingang (-) des Verstärkers (IC1) als auch über eine zweite und dritte Kopplungskapazität (C3 bzw. C4)) auf die erste und zweite Kopplungsimpedanz (D1, D2, R3; D3, D4, R4) rückgekoppelt ist (Fig. 4).

5. Verstärkerschaltung nach einem der Ansprüche 1 bis 3, **dadurch gekennzeichnet, daß** das Ausgangssignal (S2) des Verstärkers (IC1) mit einem Teilbetrag (R5/R6) seiner Amplitude sowohl auf den invertierenden Eingang (-) des Verstärkers (IC1) als auch über eine zweite und dritte Kopplungskapazität (C3 bzw. C4)) auf die erste und zweite Kopplungsimpedanz (D1, D2, R3; D3, D4, R4) rückgekoppelt ist (Fig. 5). eine zweite bzw. dritte Kopplungskapazität (C3 bzw. C4) auf die Kopplungsimpedanzen (D1, D2, R3 bzw. D3, D4, R4) rückgekoppelt (Fig. 3).

## Claims

1. Amplifier circuit for audio-frequency signals, having a condenser microphone capsule as a capacitive voltage source which, to allow its operating point to be determined, is coupled to a first source of bias voltage (Vbias1) via a first coupling impedance (R3, D1; R3, D1, D2), having an amplifier (IC1) which, to allow its operating point to be determined, is coupled by its non-inverting input to a second source of bias voltage (Vbias2) via a second coupling impedance (R4, D3; R4, D3, D4), and having a coupling capacitor (C2) which is arranged on the signal path between the capsule and the amplifier (IC1), **characterised in that** the first and second coupling impedances (R3, D1; R3, D1, D2; R4, D3; R4, D3, D4) each comprise, connected in series, a non-linear resistor (D1; D1, D2; D3; D3, D4) and respective first and second ohmic resistors (R3: R4) of relatively low resistance, the non-linear resistor being conductive on the signal path between the capsule and amplifier (IC1) during the charging times of the capacitance (C1) of the condenser microphone capsule and the coupling capacitor (C2), so that the said charging times are determined by the respective first and second ohmic resistors (R3, R4) of low resistance, and the non-linear resistance (D1; D1, D2; D3; D3, D4) in each coupling impedance assuming a high level of resistance on the signal path between the capsule and amplifier (IC1) once the charging of the capacitance (C1), the condenser microphone capsule and the coupling capacitor (C2) has taken place, so that only a very low noise voltage is generated by the non-linear resistor in each coupling impedance, and **in that** the output signal (S2) from the amplifier (IC1), or a signal derived therefrom, is fed back to the first and second coupling impedances.

2. Amplifier circuit according to claim 1, **characterised in that** respective diodes (D1 and D3) are provided as first and second non-linear resistors.

3. Amplifier circuit according to claim 1 or 2, **characterised in that** respective pairs of diodes connected in anti-parallel (D1, D2 and D3, D4) are provided as first and second non-linear resistors.

4. Amplifier circuit according to one of claims 1 to 3, **characterised in that** the output signal (S2) from the amplifier (IC1) is fed back at its full amplitude both to the inverting input (-) of the amplifier (IC1) and also, via second and third coupling capacitors (C3 and C4 respectively), to the first and second coupling impedances (D1; D1, D2; D3; D3, R4) (Fig. 4).

5. Amplifier circuit according to one of claims 1 to 3, **characterised in that** the output signal (S2) from the amplifier (IC1) is fed back at part (R5/R6) of its amplitude both to the inverting input (-) of the amplifier (IC1) and also, via second and third coupling capacitors (C3 and C4 respectively), to the first and second coupling impedances (D1; D1, D2; D3; D3, R4) (Fig. 5).

## Revendications

1. Circuit amplificateur pour des signaux à fréquence acoustique, avec une cartouche à microphone électrostatique comme source de tension capacitive, qui est couplée à une première source de pré-tension (Vbias1) au moyen d'une première impédance de couplage (R3, D1 ; R3, D1, D2) pour la détermination de son point de travail, avec un amplificateur (IC1), qui, pour la détermination de son point de travail, est couplé avec son entrée non inversante au moyen d'une seconde impédance de couplage (R4, D3 ; R4, D3, D4) à une seconde source de pré-tension (Vbias2), et avec une capacité de couplage (C2), qui est disposée dans le chemin du signal entre la cartouche et l'amplificateur (IC1), **caractérisé en ce que** la première et la seconde impédances de couplage (R3, D1 ; R3, D1, D2 ; R4, D3 ; R4, D3, D4) se composent respectivement d'un montage en série d'une résistance non linéaire (D1 ; D1, D2 ; D3 ; D3, D4) et d'une première ou seconde résistance ohmique (R3 ; R4) avec une valeur de résistance relativement faible, la résistance non linéaire étant conductrice pendant les durées de charge de la capacité (C1) de la cartouche à microphone électrostatique et de la capacité de couplage (C2) dans le chemin du signal entre la cartouche et l'amplificateur (IC1), de sorte que ces temps de charge sont déterminés par la première ou seconde résistance ohmique (R3, R4) de basse impédance, et la résistance non linéaire (D1 ; D1, D2 ; D3 ; D3, D4) présentant une valeur de résistance élevée dans chaque impédance de couplage après le chargement effectué de la capacité (C1), de la cartouche à microphone électrostatique et de la capacité de couplage (C2) dans le chemin du signal entre la cartouche et l'amplificateur (IC1), de sorte que la résistance non linéaire génère dans chaque impédance de couplage seulement une très faible tension de bruit, et **en ce que** le signal de sortie (S2) de l'amplificateur (IC1) ou un signal dérivé de celui-ci est injecté sur la première et la seconde impédances de couplage.

2. Circuit amplificateur selon la revendication 1, **caractérisé en ce que** à chaque fois une diode (D1 ou D3) est prévue comme première et seconde résistances non linéaires.

3. Circuit amplificateur selon la revendication 1 ou 2, **caractérisé en ce que** à chaque fois un circuit antiparallèle de secondes diodes (D1, D2 ou D3, D4) est prévu comme première et seconde résistances non linéaires.

4. Circuit amplificateur selon l'une quelconque des revendications 1 à 3, **caractérisé en ce que** le signal de sortie (S2) de l'amplificateur (IC1) est réinjecté avec la pleine valeur de son amplitude aussi bien sur l'entrée (-) inversante de l'amplificateur (IC1) que également au moyen d'une seconde et d'une troisième capacités de couplage (C3 et C4) sur la première et la seconde impédances de couplage (D1, D2, R3 ; D3, D4, R4) (figure 4).

5. Circuit amplificateur selon l'une quelconque des revendications 1 à 3, **caractérisé en ce que** le signal de sortie (S2) de l'amplificateur (IC1) est réinjecté avec une valeur partielle (R5/R6) de son amplitude aussi bien sur l'entrée (-) inversante de l'amplificateur (IC1) que également au moyen d'une seconde et une troisième capacités de couplage (C3 et C4) sur la première et la seconde impédances de couplage (D1, D2, R3 ; D3, D4, R4) (figure 5).
